Europäisches Patentamt

European Patent Office

Office européen des brevets

(19)

(11) **EP 0 727 669 B1**

(12) **EUROPÄISCHE PATENTSCHRIFT**

(45) Veröffentlichungstag und Bekanntmachung des Hinweises auf die Patenterteilung:
**20.03.2002   Patentblatt 2002/12**

(51) Int Cl.7: **G01R 19/32**, G01D 3/028, G01R 21/14

(21) Anmeldenummer: **95119021.4**

(22) Anmeldetag: **02.12.1995**

(54) **Anordnung zur Temperaturkompensation**

Temperature compensation means

Dispositif de compensation de température

(84) Benannte Vertragsstaaten:
**AT CH DE GB LI**

(30) Priorität: **17.02.1995   CH 47095**

(43) Veröffentlichungstag der Anmeldung:
**21.08.1996   Patentblatt 1996/34**

(73) Patentinhaber: **Siemens Metering AG**
**6300 Zug (CH)**

(72) Erfinder:
• **Petr, Jan**
**CH-6317 Oberwil (CH)**

• **Jeker, Erich**
**CH-6340 Baar (CH)**

(74) Vertreter: **Zedlitz, Peter, Dipl.-Inf. et al**
**Patentanwalt,**
**Postfach 22 13 17**
**80503 München (DE)**

(56) Entgegenhaltungen:
**EP-A- 0 382 217**          **EP-A- 0 457 582**
**WO-A-93/24992**          **US-A- 4 833 406**
**US-A- 5 254 992**

**Beschreibung**

Die Erfindung bezieht sich auf eine Anordnung zur Temperaturkompensation gemäss dem Oberbegriff des Anspruchs 1.

Die erfindungsgemässe Anordnung wird vorzugsweise in Energie- und/oder Leistungs-Messgeräten verwendet, wie z. B. Elektrizitätszählern, um deren Messresultate temperaturunabhängig zu machen.

Bekannt ist, den Temperaturkoeffizienten eines Hallelementes zu kompensieren mit Hilfe des Temperaturkoeffizienten eines parallel zum Hallelement geschalteten Widerstandes. Aus Electronics Letters, 7. 1. 82, Vol. 18, No1, Seiten 24 bis 25, "Bandgap voltage reference sources in CMOS technology", R. Ye und Y. Tsividis, ist ausserdem ein innerer Aufbau einer bekannten "Bandgap"-Referenzspannungsquelle in CMOS-Technologie bekannt.

Aus der EP-A-0 382 217 ist eine Anordnung bekannt, die zur Temperaturkompensation der Empfindlichkeit einer Messbrücke mit nachgeschalteter Signalverarbeitungsanordnung geeignet ist, wobei zur Temperaturkompensation der Messempfindlichkeit die Versorgungsspannung des Sensors angepasst wird.

Der Erfindung liegt die Aufgabe zugrunde, eine Anordnung der eingangs genannten Art zu verwirklichen, welche, trotz Temperaturkoeffizient-Streuungen zwischen verschiedenen Exemplaren der erfindungsgemässen Anordnung, eine individuelle, schnelle, kostengünstige und automatisch abgleichbare Temperaturkompensation ermöglicht.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:

Fig. 1    ein prinzipielles Blockschaltbild einer erfindungsgemässen Anordnung,

Fig. 2    ein vereinfachtes Schaltbild einer erfindungsgemässen Referenzspannungsquelle und

Fig. 3    ein Blockschaltbild eines Teils eines Energie- und/oder Leistungs-Messgerätes mit einer externen Messeinrichtung und einem externen Computer.

Nachfolgend sind jeweils die von einer Temperatur T abhängigen Parameter mit einem Index T, die von einem digitalen Abgleichwert N abhängigen Parameter mit einem Index N und die sowohl von der Temperatur T als auch von dem Abgleichwert N abhängigen Parameter mit einem Index N,T versehen. Dabei bezeichnet T eine absolute Temperatur in °K.

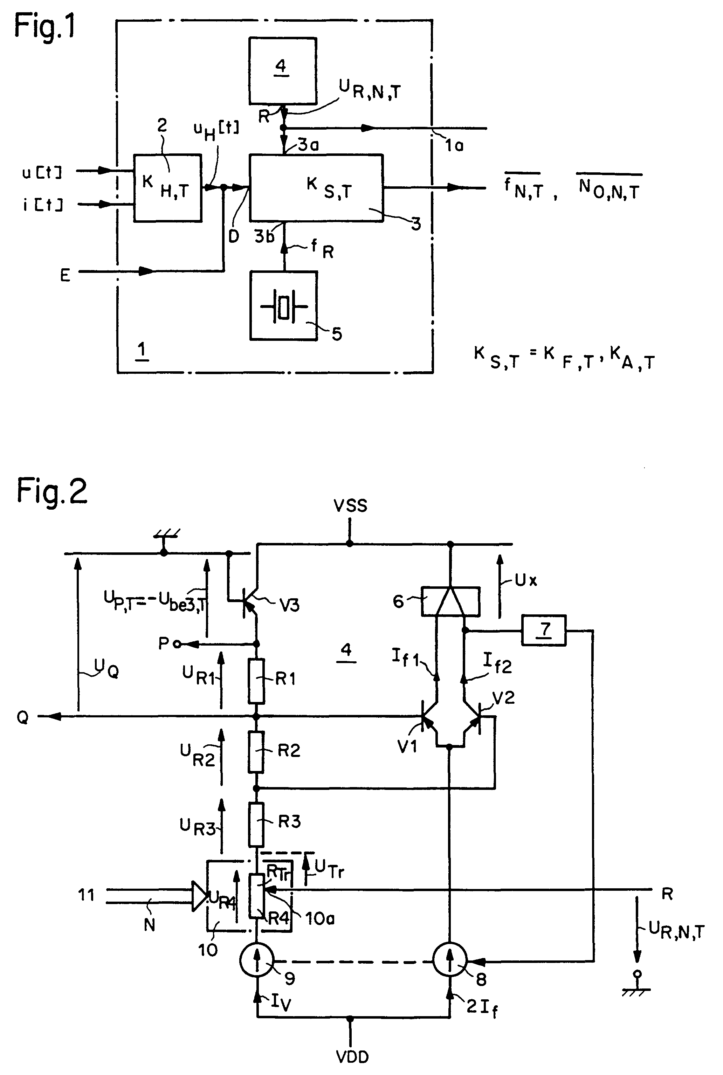

In einem Energie- und/oder Leistungs-Messgerät 1 (siehe Fig. 1) ist ein Sensor 2 vorhanden zum Messen eines von der Zeit t abhängigen elektrischen Stromes i[t] und einer dazugehörigen, ebenfalls von der Zeit t abhängigen elektrischen Spannung u[t]. Der Strom i[t] ist z. B. ein Wechselstrom, während die Spannung u[t] dann eine Wechselspannung ist. Der Sensor 2 besitzt in der Regel einen temperaturabhängigen Übertragungsfaktor $K_{H,T}$. Er ist z. B., was in der Zeichnung nicht dargestellt ist, ein Hallelement (daher der verwendete Index H), welches in einem Luftspalt eines Magnetkreises zwischen einem Hinleiter und einem Rückleiter einer U-förmigen Stromschlaufe angeordnet ist. Ein Speisestromeingang des Hallelementes ist dann im Betrieb über einen Vorwiderstand von der Spannung u[t] gespeist, während die U-förmige Stromschlaufe vom Strom i[t] durchflossen wird. Die Ausgangsspannung $u_H[t]$ des Sensors 2 ist proportional dem Produkt u[t].i[t], welches ein Analogwert der zum Strom i[t] gehörigen Leistung p[t] ist. Der Sensor 2 ist somit eine Anordnung zur Ermittlung des analogen Leistungswertes p[t]. Dem Sensor 2 ist eine Signalverarbeitungsanordnung 3 in Reihe nachgeschaltet zur Aufbereitung und Weiterverarbeitung der ermittelten analogen Leistungswerte p[t]. Die Signalverarbeitungsanordnung 3 besitzt in der Regel ebenfalls einen temperaturabhängigen Übertragungsfaktor $K_{S,T}$. Der temperaturabhängige Übertragungsfaktor $K_{H,T}.K_{S,T}$ der Gesamtanordnung 2;3 ist temperaturunabhängig zu machen. Zu diesem Zweck ist der Übertragungsfaktor $K_{S,T}$ der Signalverarbeitungsanordnung 3 erfindungsgemäss umgekehrt proportional einer temperaturabhängigen Referenzspannung $U_{R,N,T}$ einer Referenzspannungsquelle 4, welche räumlich so nahe beim Sensor 2 und der Signalverarbeitungsanordnung 3 angeordnet ist, dass sie im Betrieb ein gleiche Temperatur T aufweist wie die beiden letzteren. Die Signalverarbeitungsanordnung 3 wird über einen ersten Referenzsignaleingang 3a von einem Ausgang R der Referenzspannungsquelle 4 mit der Referenzspannung $U_{R,N,T}$ gespeist. Der Ausgang R bildet gleichzeitig einen Referenzspannungs-Ausgang 1a des Energie- und/oder Leistungs-Messgerätes 1, an dem die Referenzspannung $U_{R,N,T}$ ansteht. Ein Referenzfrequenzgenerator 5, in der eine Referenzfrequenz $f_R$ erzeugt wird, speist die Signalverarbeitungsanordnung 3 über einen zweiten Referenzsignaleingang 3b mit einem Taktsignal der Frequenz $f_R$.

Die Signalverarbeitungsanordnung 3 ist vorzugsweise ein Spannungs/Frequenz-Wandler mit $K_{S,T} = K_{F,T}$ oder ein Analog/Digital-Wandler mit $K_{S,T} = K_{A,T}$. Im letzteren Fall ist ein digitaler mittlerer Ausgangswert $\overline{N_{O,N,T}}$ der Signalverarbeitungsanordnung 3 und im ersteren Fall eine mittlere Ausgangsfrequenz $\overline{f_{N,T}}$ der Signalverarbeitungsanordnung 3 proportional einem mittleren Wert $\overline{u_H[t]}$ der Ausgangsspannung $u_H[t]$ des Sensors 2 und damit proportional einem mittleren Wert $\overline{p[t]}$ der Leistung p[t].

Für den Sensor 2 gelten folgende Gleichungen:

$$\overline{u_H[t]} = K_{H,T}\cdot \overline{u[t]\cdot i[t]} = K_{H,T}\cdot \overline{p[t]}$$

$$\text{mit } K_{H,T} = K_{H,0}\cdot\{1 + \alpha_H\cdot\Delta T\} = K_{H,0} + a_H\cdot \Delta T \text{ und}$$

$$a_H = K_{H,0}\ \alpha_H \qquad\qquad [I]$$

Dabei sind:

$K_{H,0}$ ein Wert von $K_{H,T}$ bei einer Referenztemperatur $T_0$,
$\Delta T$ eine Differenz zwischen der Temperatur T und der Referenztemperatur $T_0$,
$a_H$ ein absoluter Temperaturkoeffizient des Übertragungsfaktors $K_{H,T}$ und
$\alpha_H$ ein relativer Temperaturkoeffizient des Übertragungsfaktors $K_{H,T}$.

Im Fall des Spannungs/Frequenz-Wandlers gelten, unter Vernachlässigung eines Terms zweiter Ordnung, für die Signalverarbeitunganordnung 3 folgende Gleichungen:

$$\overline{f_{N,T}} = K_{F,T}\cdot\overline{u_H[t]} = K_{F,T}\cdot K_{H,T}\cdot\overline{p[t]} = \{K_{H,T}\cdot M_{F,T}\cdot f_R/U_{R,N,T}\}\cdot\overline{p[t]} \qquad [II]$$

$$= \{K_{H,0}\cdot M_{F,0}\cdot f_R\cdot[1 + \alpha_H.\Delta T][1 + \alpha_F\ \Delta T]/U_{R,N,T}\}\cdot\overline{p[t]}$$

$$= \{K_{H,0}\cdot M_{F,0}\cdot f_R\cdot[1 + (\alpha_H + \alpha_F).\Delta T]/U_{R,N,T}\}\cdot\overline{p[t]}$$

$$\text{mit } K_{F,T} = M_{F,T}\cdot f_R/U_{R,N,T}$$

$$M_{F,T} = M_{F,0}\cdot\{1 + \alpha_F\ \Delta T\} = M_{F,0} + a_F\ \Delta T \qquad [III]$$

$$a_F = M_{F,0}\cdot\alpha_F$$

Im Fall des Analog/Digital-Wandlers gelten, unter Vernachlässigung eines Terms zweiter Ordnung, für die Signalverarbeitungsanordnung 3 folgende Gleichungen:

$$\overline{N_{O,N,T}} = K_{A,T}\cdot\overline{u_H[t]} = K_{A,T}\cdot K_{H,T}\cdot\overline{p[t]} = \{K_{H,T}\cdot M_{A,T}\cdot A/U_{R,N,T}\}\cdot\overline{p[t]}$$

$$= \{K_{H,0}\cdot M_{A,0}\cdot A\cdot[1 + \alpha_H.\Delta T][1 + \alpha_A\ \Delta T]/U_{R,N,T}\}\cdot\overline{p[t]}$$

$$= \{K_{H,0}\cdot M_{A,0}\cdot A\cdot[1 + (\alpha_H + \alpha_A).\Delta T]/U_{R,N,T}\}\cdot\overline{p[t]}$$

$$\text{mit } K_{A,T} = M_{A,T}\cdot\{f_R/f_p\}/U_{R,N,T} = M_{A,T}\cdot A/U_{R,N,T}$$

$$f_R/f_p = A$$

$$M_{A,T} = M_{A,0}\cdot\{1 + \alpha_A\ \Delta T\} = M_{A,0} + a_A\ \Delta T \qquad [IIIa]$$

$$a_A = M_{A,0}\cdot\alpha_A$$

Für die temperaturabhängige Referenzspannung $U_{R,N,T}$ gelten folgende Gleichungen:

$$U_{R,N,T} = U_{R,N,0}\cdot\{1 + \alpha_{R,N}\cdot \Delta T) = U_{R,N,0} + a_{R,N}\cdot \Delta T \qquad [IV]$$

$$\text{mit } a_{R,N} = U_{R,N,0}\ \alpha_{R,N} \qquad [IVa]$$

Dabei sind:

$M_{F,T}$ und $M_{A,T}$ zwei temperaturabhängige Proportionalitätskonstanten,

$U_{R,N,0}$, $M_{F,0}$ und $M_{A,0}$ Werte von $U_{R,N,T}$, $M_{F,T}$ und $M_{A,T}$ bei der Referenztemperatur $T_0$,

$\alpha_{R,N}$ ein relativer Temperaturkoeffizient der Referenzspannung $U_{R,N,T}$,

$\alpha_F$ und $\alpha_A$ relative Temperaturkoeffizienten der Proportionalitätskonstanten $M_{F,T}$ und $M_{A,T}$ und damit relative Temperaturkoeffizienten des Übertragungsfaktors $K_{F,T}$ bzw. $K_{A,T}$, wenn die Referenzspannung $U_{R,N,T}$ temperaturunabhängig ist, d. h. sie sind relative Temperaturkoeffizienten der Signalverarbeitungsanordnung 3 des nichttemperaturkompensierten Energie- und/oder Leistungs-Messgerätes 1,

$a_{R,N}$ ein absoluter Temperaturkoeffizient der Referenzspannung $U_{R,N,T}$,

$a_F$ und $a_A$ absolute Temperaturkoeffizienten der Proportionalitätskonstanten $M_{F,T}$ und $M_{A,T}$ und damit absolute Temperaturkoeffizienten des Übertragungsfaktors $K_{F,T}$ bzw. $K_{A,T}$, wenn die Referenzspannung $U_{R,N,T}$ temperaturunabhängig ist, d. h. sie sind absolute Temperaturkoeffizienten der Signalverarbeitungsanordnung 3 des nichttemperaturkompensierten Energie- und/oder Leistungs-Messgerätes 1, und

$f_p$ eine Datenrate des digitalen Ausgangswertes des Analog/Digital-Wandlers.

Erfindungsgemäss ist ein zur Temperaturkompensation erforderlicher Wert $\alpha_{R,N,Soll}$ des Temperaturkoeffizienten $\alpha_{R,N}$ der temperaturabhängigen Referenzspannung $U_{R,N,T}$ gleich einer Summe des Temperaturkoeffizienten $\alpha_H$ des Übertragungsfaktors $K_{H,T}$ des Sensors 2 und des Temperaturkoeffizienten $\alpha_F$ bzw. $\alpha_A$ des Übertragungsfaktors $K_{F,T}$ bzw. $K_{A,T}$ der Signalverarbeitungsanordnung 3 des nichttemperaturkompensierten Energie- und/oder Leistungs-Messgerätes 1. Es gilt somit:

$$\alpha_{R,N,Soll} = \alpha_H + \alpha_F \text{ bzw. } \alpha_{R,N,Soll} = \alpha_H + \alpha_A \qquad [V]$$

In diesem Fall ist sowohl beim Spannungs/Frequenz-Wandler die mittlere Ausgangsfrequenz

$$\overline{f_{N,T}} = \{K_{H,0}.M_{F,0}.f_R.[1 + (\alpha_H. + \alpha_F).\Delta T]/U_{R,N,T}\}.\overline{p[t]}$$

$$= \{K_{H,0}.M_{F,0}.f_R.[1 + (\alpha_H. + \alpha_F).\Delta T]/[U_{R,N,0}(1 + \alpha_{R,N,Soll}.\Delta T)]\}.\overline{p[t]}$$

$$= \{K_{H,0}.M_{F,0}.f_R./U_{R,N,0}\}.\overline{p[t]}$$

als auch beim Analog/Digital-Wandler der digitale mittlere Ausgangswert

$$\overline{N_{O,N,T}} = \{K_{H,0}.M_{A,0}.A.[1 + (\alpha_H. + \alpha_A).\Delta T]/U_{R,N,T}\}.\overline{p[t]}$$

$$= \{K_{H,0}.M_{A,0}.A.[1 + (\alpha_H. + \alpha_A).\Delta T]/[U_{R,N,0}.(1 + \alpha_{R,N,Soll}.\Delta T)]\}\, \overline{p[t]}$$

$$= \{K_{H,0}.M_{A,0}.A./U_{R,N,0}\}\, \overline{p[t]}$$

temperaturunabhängig.

Der relative Temperaturkoeffizient $\alpha_H$ des Sensors 2 besitzt z. B. mit einem Hallelement einen Erfahrungs-Mittelwert 765 ppm/°K, wobei der Temperaturkoeffizient des Magnetkreises mitberücksichtigt ist.

Der relative Temperaturkoeffizient $\alpha_F$ des Spannungs/Frequenz-Wandlers besitzt z. B. einen Erfahrungs-Mittelwert -30 ppm/K. Um einen genaueren Wert zu erhalten, der die Exemplarstreuungen berücksichtigt, wird er jedoch vorzugsweise mittels einer Zweitemperatur-Messung der mittleren Ausgangsfrequenz $\overline{f_{N,T}}$ des Messgerätes 1 ermittelt. In diesem Fall wird die Ausgangsfrequenz $\overline{f_{N,T}} = \overline{f_{0,35}}$ bei einer ersten Temperatur, z. B. bei der Referenztemperatur $T_0 = 35°C$, und die Ausgangsfrequenz $\overline{f_{N,T}} = \overline{f_{0,85}}$ bei einer zweiten Temperatur $T_1$, z. B. bei 85°C, gemessen mit jeweils z. B. N = 0. Die Differenz $\Delta T = T_1 - T_0$ der beiden Temperaturen $T_1$ und $T_0$ soll dabei mindestens 50°C betragen. Ausserdem wird die Referenzspannung $U_{R,N,T} = U_{R,0,85}$ bzw. $U_{R,N,T} = U_{R,0,35}$, ebenfalls mit N = 0, jeweils bei den beiden Temperaturen $T_1$ und $T_0$ gemessen. Das Messgerät 1 ist mit Ausnahme des Sensors 2 vorzugsweise als integrierte Halbleiterschaltung ausgeführt. Die Messungen und eine nachfolgende Programmierung erfolgen dann vorzugsweise bereits anlässlich von "Wafer"-Testmessungen, d. h. zu einem Zeitpunkt, da der Sensor 2 noch nicht vorhanden und noch nicht an der Signalverarbeitungsanordnung 3 angeschlossen ist. Ein Eingang D der letzteren (siehe Fig. 1), der gleichzeitig ein Eingang E des Messgerätes 1 ist, wird deshalb während der Messungen statt von der Ausgangspannung $u_H[t]$ des Sensors 2 von einer Gleichspannung $U_H$ gespeist, deren Wert vorbekannt ist. Die Gleichungen [I] und [II] ergeben in diesem Fall:

$$U_H = K_{H,T} \cdot \overline{p[t]}$$

$$M_{F,T} = [\overline{f_{N,T}} \cdot U_{R,N,T}]/[f_R \cdot K_{H,T} \cdot \overline{p[t]}] = [\overline{f_{N,T}} \cdot U_{R,N,T}]/[f_R \cdot U_H],$$

was bei einer Zweitemperatur-Messung zwei Gleichungen ergibt:

$$M_{F,85} = [\overline{f_{0,85}} \cdot U_{R,0,85}]/[f_R \cdot U_H],$$

$$M_{F,35} = [\overline{f_{0,35}} \cdot U_{R,0,35}]/[f_R \cdot U_H],$$

wobei die Referenzfrequenz $f_R$ vorbekannt ist.

Die Gleichung [III] ergibt dann:

$$\alpha_F = [M_{F,85} - M_{F,35}] / [M_{F,35} \, \Delta T] \text{ mit } \Delta T = 50°C.$$

Falls die Signalverarbeitungsanordnung 3 ein Analog/Digital-Wandler ist, ergibt die Gleichung [IIIa] auf ähnliche Art:

$$\alpha_A = [M_{A,85} - M_{A,35}] / [M_{A,35} \, \Delta T] \text{ mit } \Delta T = 50°C.$$

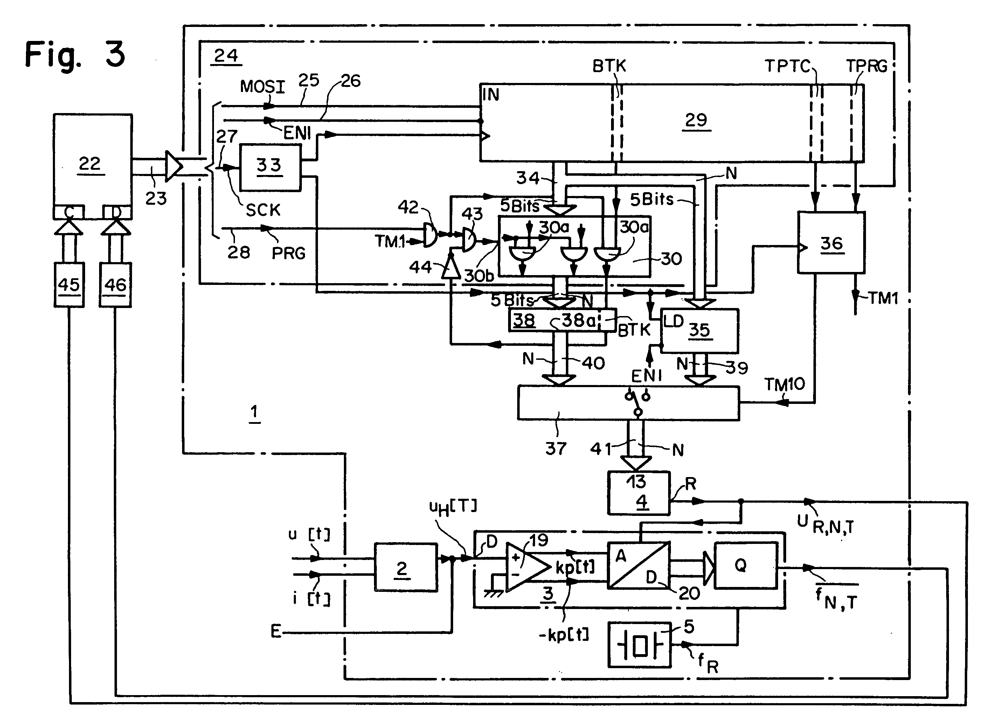

Da die Temperaturkoeffizienten starken Exemplarstreuungen unterworfen sind und daher von Exemplar zu Exemplar der Anordnung unterschiedlich sind, muss die Gleichung $\alpha_{R,N,Soll} = \alpha_H + \alpha_F$ bzw. $\alpha_{R,N,Soll} = \alpha_H + \alpha_A$ jeweils für jede Anordnung individuell eingestellt werden. Zu diesem Zweck ist der zur Temperaturkompensation erforderliche Wert $\alpha_{R,N,Soll}$ des Temperaturkoeffizienten $\alpha_{R,N}$ der temperaturabhängigen Referenzspannung $U_{R,N,T}$ für jede Anordnung individuell und vorzugsweise mittels des in einem Speicher der Anordnung (siehe Speicher 38 in der Fig. 3) unverlierbar gespeicherten digitalen Abgleichwertes N so programmierbar, dass er gleich der Summe des relativen Temperaturkoeffizienten $\alpha_H$ des Übertragungsfaktors $K_{H,T}$ des zugehörigen Sensors 2 und des relativen Temperaturkoeffizienten $\alpha_F$ bzw. $\alpha_A$ des Übertragungsfaktors $K_{F,T}$ bzw. $K_{A,T}$ der zugehörigen Signalverarbeitungsanordnung 3 des nichttemperaturkompensierten Energie- und/oder Leistungs-Messgerätes 1 ist.

Die in der Fig. 2 dargestellte Referenzspannungsquelle 4 ist vorzugsweise eine "Bandgap"-Referenzspannungsquelle, in der eine temperaturunabhängige erste Referenzspannung $U_Q$, die temperaturabhängige zweite Referenzspannung $U_{R,N,T}$ und eine temperaturabhängige dritte Referenzspannung $U_{P,T}$ erzeugt werden, die alle drei auf Masse bezogen und auf je einen getrennten Ausgang Q oder R bzw. Messpunkt P der Referenzspannungsquelle 4 geführt sind. Die Werte der Referenzspannung $U_{R,N,T}$ und deren Temperaturkoeffizient $a_{R,N,T}$ sind von der Temperatur T abhängig und mittels des digitalen Abgleichwertes N programmierbar.

Drei nachfolgend erwähnte Transistoren V1, V2 und V3 sind entweder NPN- oder PNP-Bipolartransistoren. Nachfolgend und in der Fig. 2 gilt die Annahme, das letzteres der Fall ist. Die Referenzspannungsquelle 4 enthält vorzugsweise einen Stromspiegel 6, dessen erster Anschluss mit einem Kollektor eines ersten Transistors V1 und dessen zweiter Anschluss mit einem Kollektor eines zweiten Transistors V2 sowie über einen Regelverstärker 7 mit je einem Steuereingang einer ersten und zweiten Stromquelle 8 bzw. 9 der Referenzspannungsquelle 4 verbunden ist. Ein dritter Anschluss des Stromspiegels 6 liegt vorzugsweise an einer auf Masse bezogenen negativen Gleichspannung VSS. Die Emitter der Transistoren V1 und V2 sind miteinander und über die Stromquelle 8, die gemeinsam beide Emitter speist, mit einer auf Masse bezogenen positiven Gleichspannung VDD verbunden. Die Transistoren V1 und V2 dienen unter anderem als Eingangsstufe des Regelverstärkers 7, was dessen effektive Nullspannung ("offset voltage") niedrig, d. h. kleiner 1 mV hält, was wichtig ist, da ein in der Referenzspannungsquelle 4 verwendetes Nutzsignal $\Delta U_{be}$ nur einen relativ kleinen Wert von 50 bis 60 mV besitzt. Eine Basis/Emitter-Strecke eines dritten Transistors V3, ein Widerstand R1, ein Widerstand R2, ein Widerstand R3, ein Gesamtwiderstand R4 eines Trimm-Potentiometers 10 und die Stromquelle 9 sind in der Referenzspannungsquelle 4 in der angegebenen Reihenfolge in Reihe geschaltet.

Die Widerstände R3 und R4 sind somit in der Reihenschaltung zwischen der Stromquelle 9 und dem Widerstand R2 angeordnet. Der Widerstand R4 ist dabei dort zwischen dem Widerstand R3 und der Stromquelle 9 vorhanden. Der Emitter des Transistors V3 ist zwecks Bildung der Reihenschaltung V3;R1;R2;R3;R4;9 mit einem Anschluss des Widerstandes R1 verbunden und bildet den Messpunkt P der Referenzspannungsquelle 4. Eine Basis des Transistors V3 liegt an Masse, während ein Kollektor des letzteren in einer bevorzugten Ausführung an der negativen Gleichspannung VSS liegt. Dieser Kollektor kann aber auch in einer nicht bevorzugten Ausführung an Masse liegen. Die Basis des Transistors V3 bildet einen ersten, an Masse liegenden Anschluss der Reihenschaltung V3;R1;R2;R3;R4;9. Ein nicht unmittelbar mit dem Trimm-Potentiometer 10 verbundener Anschluss der Stromquelle 9 bildet einen zweiten Anschluss der Reihenschaltung V3;R1;R2;R3;R4;9 und liegt an der positiven Gleichspannung VDD. Ein gemeinsamer Anschluss der Widerstände R1 und R2 ist mit einer Basis des Transistors V1 verbunden und bildet den Ausgang Q der Referenzspannungsquelle 4. Ein gemeinsamer Anschluss der Widerstände R2 und R3 ist mit einer Basis des Transistors V2 verbunden. Die beiden Anschlüsse des Widerstandes R2 sind somit mit je einer Basis der beiden Transistoren V1 und V2 verbunden. Ein Abgriff 10a des Trimm-Potentiometers 10 bildet den Ausgang R der Referenzspannungsquelle 4, an dem im Betrieb die temperaturabhängige Referenzspannung $U_{R,N,T}$ ansteht. Ein Strom $I_v$ der Stromquelle 9 wird mittels des Regelverstärkers 7 so geregelt, dass die Kollektorströme $I_{f1}$ und $I_{f2}$ der Transistoren V1 und V2 immer gleich gross sind, so dass $I_{f1} = I_{f2} = I_f$. Die beiden Stromquellen 8 und 9 sind so miteinander gekoppelt, dass ihre beiden Ströme $2I_f$ und $I_v$ proportional zueinander sind.

Ist z. B. der Kollektorstrom $I_{f2}$ des Transistors V2 zu klein, so sinkt der Wert des Spannungsabfalls $U_x$ über den Stromspiegel 6, der gleichzeitig die Eingangsspannung des Regelverstärkers 7 ist, wodurch der Strom $I_v$ der Stromquelle 9 kleiner wird, da $I_v$ proportional G.Ux ist, wenn G einen Verstärkungsfaktor des Regelverstärkers 7 darstellt. Bedingt durch den dann entstehenden kleineren Spannungsabfall über R1 und R2 steigt die Basis-Emitter-Spannung $U_{be2}$ des Transistors V2 an, so dass dessen Kollektorstrom $I_{f2}$ wieder ansteigt.

Für den Transistor V1 gelten folgende Gleichungen:

$$I_{C1} = I_{S1} . e^{[q/KT].U}be1$$

$$U_{be1} = [KT/q].\ln[I_{C1}/I_{S1}]$$

$$I_{S1} = [q.n_i^2 .D/N_B].A_1$$

Dabei ist $I_{C1}$ der Kollektorstrom, $U_{be1}$ die Basis/Emitter-Spannung, $I_{S1}$ der theoretische Sperrstrom der Basis/Emitter-Strecke und $A_1$ die Emitterfläche des Transistors V1.

Generell sind ausserdem:

K = $1{,}38066.10^{-23}$ J/K die Boltzmannkonstante,
q = $1{,}60212.10^{-19}$ Coulomb die Elementarladung eines Elektrons,
$n_i$ = $2.10^{11}$ cm$^{-3}$ die "Intrisic"-Trägerdichte,
D die Diffusionskonstante in cm$^2$/Sekunde und
$N_B$ = $2{,}5.10^{16}$ cm$^{-3}$ die "Bulk"-Dotierung.

Für den Transistor V2 gelten folgende Gleichungen:

$$I_{C2} = I_{S2} . e^{[q/KT].U}be2$$

$$U_{be2} = [KT/q].\ln[I_{C2}/I_{S2}]$$

$$I_{S2} = [q.n_i^2 .D/N_B].A_2$$

Dabei ist $I_{C2}$ der Kollektorstrom, $U_{be2}$ die Basis/Emitter-Spannung, $I_{S2}$ der theoretische Sperrstrom der Basis/Emitter-Strecke und $A_2$ die Emitterfläche des Transistors V2.

Dies ergibt durch Differenzbildung für den Spannungsabfall $U_{R2}$ über den Widerstand R2 die Gleichung:

$$\Delta U_{be} = U_{be1} - U_{be2} = [KT/q].\{\ln[I_{C1}/I_{S1}] - \ln[I_{C2}/I_{S2}]\} = [KT/q].\ln\{[I_{C1}/I_{C2}].[I_{S2}/I_{S1}]\}$$

$$= [KT/q].\ln\{[I_{C1}/I_{C2}].[A_2/A_1]\} = U_{R2}$$

Aus der letzten Gleichung ist ersichtlich, dass $\Delta U_{be}$ ausser von der absoluten Temperatur T nur von physikalischen Konstanten K und q sowie dem Stromdichteverhältnis $[I_{C1}/A_1]/[I_{C2}/A_2]$ abhängig ist.

Der Transistor V2 besteht z. B. aus acht gleichen Transistoren vom Typ V1, welche letztere somit je einen Kollektorstrom $I_{C1}/8$ aufweisen, da die Kollektorströme $I_{C1}$ und $I_{C2}$ der beiden Transistoren V1 und V2 gleich sind. $A_2$ ist somit $8A_1$. Dies ergibt:

$$U_{R2} = \Delta U_{be} = [K.T/q].\ln 8$$

$$I_v = U_{R2}/R2 = \{[K.T]/[q.R2]\}\ln 8 \qquad\qquad [VI]$$

Der Strom $I_v$ der zweiten Stromquelle 9 ist somit proportional der absoluten Temperatur T und besitzt einen positiven Temperaturkoeffizienten. Unter Vernachlässigung der Basisströme der Transistoren V1 und V2 speist die Stromquelle 9 alle Widerstände R1 bis R4 mit dem gleichen Strom $I_v$. Da der Temperaturkoeffizient der als Polysilizium-Halbleiterwiderstände hergestellten Widerstände R1 bis R4 klein ist, besitzen die durch den Strom $I_v$ in diesen Widerständen verursachten Spannungsabfälle $U_{R1}$, $U_{R2}$, $U_{R3}$ und $U_{R4}$ genau wie der Strom $I_v$ einen positiven Temperaturkoeffizienten und können somit zur Kompensation eines negativen Temperaturkoeffizienten, z. B. desjenigen der Basis/Emitter-Strecke des Transistors V3 verwendet werden. In der Referenzspannungsquelle 4 sind somit ein negativer Temperaturkoeffizient einer Basis/Emitter-Spannung $U_{be3,T}$ des Transistors V3 und ein positiver Temperaturkoeffizient eines Spannungsabfalls, der in einem Polysilizium-Halbleiterwiderstand R1;R2;R3;R4 mittels des einen positiven Temperaturkoeffizienten aufweisenden Stromes $I_v$ erzeugt wird, so miteinander kombiniert, dass die temperaturabhängige Referenzspannung $U_{R,N,T}$ den zur Temperaturkompensation erforderlichen Wert $\alpha_{R,N,Soll}$ (siehe Gleichung [V]) des Temperaturkoeffizienten $\alpha_{R,N}$ besitzt. Dabei sind die die Basis/Emitter-Spannung $U_{be3,T}$ aufweisende Basis/Emitter-Strecke des Transistors V3, der Polysilizium-Halbleiterwiderstand R1;R2;R3;R4 und die zweite Stromquelle 9 in der angegebenen Reihenfolge elektrisch in Reihe geschaltet. Der Polysilizium-Halbleiterwiderstand R1;R2;R3;R4 enthält mehrere elektrisch in Reihe geschaltete Widerstände, nämlich die vier Widerstände R1 bis R4. Die nahezu linearen und auch prozessunabhängigen, mit einem positiven Temperaturkoeffizienten versehenen Spannungsabfälle $U_{R1}$, $U_{R2}$, $U_{R3}$ und $U_{R4}$ werden mittels des Stromes $I_v$ gewonnen, wobei der den positiven Temperaturkoeffizienten aufweisende Strom $I_v$ aus der Differenz $\Delta U_{be}$ der Basis/Emitter-Spannungen $U_{be1}$ und $U_{be2}$ der beiden, mit unterschiedlichen Stromdichten $I_{C1}/A_1$ und $I_{C2}/A_2$ in Differenzschaltung betriebenen Transistoren V1 und V2 erzeugt wird.

Bei der Raumtemperatur 300°K ist $U_{R2} = \Delta U_{be} = 53,8$ mV und somit relativ klein.

Die Basis/Emitter-Spannung $U_{be}$ eines jeden Bipolartransistors und damit auch die Basis/Emitter-Spannung $U_{be3,T}$ des Transistors V3 ist nahezu linear abhängig von der absoluten Temperatur T, so dass für den Transistor V3 folgende Gleichung gilt:

$$U_{be3,T} = U_{Gap} - \lambda.T = - U_{P,T} \qquad\qquad [VII]$$

Dabei bezeichnet $U_{Gap} = 1,2$V die extrapolierte "Bandgap"-Spannung und $\lambda = 2,27$mV/°K der Absolutwert des Temperaturkoeffizienten der Basis/Emitter-Spannung $U_{be,T}$ eines Bipolartransistors. Die letztere besitzt somit einen relativ grossen negativen Temperaturkoeffizienten -2,27 mV/°K. Bei der Raumtemperatur T = 300°K ist die am Messpunkt P anstehende Spannung $U_{P,T} = U_{be3,T}$ etwa gleich 0,58 Volt. Um die relativ grosse Temperaturabhängigkeit von $U_{be3,T}$ zu kompensieren, wird in der Reihenschaltung V3;R1;R2;R3;R4;9 zu der den negativen Temperaturkoeffizienten aufweisenden Basis/Emitterspannung $U_{be3,T}$ eine zweite Spannung $U_{R1}$ = R1.Iv addiert, die, wie bereits erwähnt, einen positiven Temperaturkoeffizienten aufweist. Der Spannungsabfall $U_{R2} = \Delta U_{be}$ ist trotz seines positiven Temperaturkoeffizienten zu diesem Zweck nicht verwendbar, da sein relativ kleiner Wert von ca. 53,8 mV für die Kompensation des negativen Temperaturkoeffizienten der Basis/Emitter-Strecke des Transistors V3 ungenügend ist und um einen Faktor 12,5 verstärkt werden muss, was mittels des Widerstandes R1 geschieht, der dazu gleich 12,5.R2 gewählt wird. Der Spannungsabfall $U_{R1}$ ist dann annähernd gleich 0,672 Volt und damit in der gleichen Grössenordnung wie der Wert $U_{be3,T}$ = 0,58 Volt.

Die am Ausgang Q der Referenzspannungsquelle 4 anstehende temperaturunabhängige Spannung $U_Q$ ist unter Berücksichtigung der Gleichungen [VI] und [VII]:

$$U_Q = U_{R1} + U_{be3,T} = I_v.R1 + [U_{Gap} - \lambda.T] = [\Delta U_{be}/R2].R1 + [U_{Gap} - \lambda.T]$$

$$= [R1/R2].\{[K.T/q].\ln8\} + [U_{Gap} - \lambda.T]$$

Zur Erzeugung einer temperaturunabhängigen Referenzspannung $U_Q$ muss der in der Reihenschaltung zwischen der Basis/Emitter-Strecke des Transistors V3 und dem Widerstand R2 angeordnete Widerstand R1 so dimensioniert sein, dass die beiden Temperaturkoeffizienten von $U_{R1}$ und $U_{be3,T}$ sich gegenseitig aufheben und der Gesamt-Temperaturkoeffizient Null ist, d. h. mit $\lambda = 2,27$ mV/°K muss folgende Gleichung erfüllt sein:

$$dU_Q/dT = [R1/R2].[K/q].\ln8 - \lambda = 0$$

oder

$$R1/R2 = \lambda/\{[K/q].\ln8\} = 12,5$$

Der Wert 12,5 des Widerstandsverhältnisses R1/R2 ist mittels aufeinander abgestimmter Polysilizium-Halbleiterwiderstände sehr genau einstellbar. Die Spannung $U_Q$ beträgt 1,25 V ±5% und ihr Temperaturkoeffizient ±100ppm/°K. Der Ausgangswiderstand des Ausganges Q der Referenzspannungsquelle 4 ist relativ gross und der maximale Ausgangsstrom dementsprechend relativ klein.

Das oben beschriebene Prinzip kann auch verwendet werden, um die temperaturabhängige Referenzspannung $U_{R,N,T}$ zu erzeugen, deren Temperaturkoeffizient $a_{R,N,T}$ mittels des digitalen Abgleichwertes N in einem vorgegebenen Bereich einstellbar, d. h. programmierbar ist. Dazu wird wieder der durch die Widerstände R1 und R2 fliessende Strom $I_v$ verwendet, der in den Widerständen R3 und R4 zusätzliche Spannungsabfälle $U_{R3}$ und $U_{R4}$ erzeugt, die ganz oder teilweise dazu verwendet werden $U_{R,N,T}$ zu erzeugen.

Ein Programmier-Buseingang 11 der Referenzspannungsquelle 4 bildet einen digitalen Programmiereingang des Trimm-Potentiometers 10, welches in diesem Fall ein digitales Potentiometer ist. Auf diesen Programmier-Eingang ist der digitale Abgleichwert N geführt, von dem nachfolgend angenommen wird, dass er fünf Bits aufweist. Es sind somit 32 Abgleichwerte 0 bis 31 möglich. In diesem Fall besteht der Widerstand R4 des Trimm-Potentiometers 10 vorzugsweise aus 31 in Reihe geschalteten gleichgrossen kleinen Widerständen des Wertes R5, deren vom Strom $I_v$ erzeugten Spannungsabfälle über eine Vielzahl von in der Fig. 2 nicht dargestellten Schaltern, vorzugsweise 31 Umschalter, abgegriffen und teilweise summiert dem Abgriff 10a des Trimm-Potentiometers 10 zugeführt werden, indem z. B. die Umschalter mittels je eines Bits des digitalen Abgleichwertes N umgeschaltet werden. Die Programmierung geschieht somit innerhalb des Trimm-Potentiometers 10 durch ein Umschalten des Spannungsabgriffs 10a des Trimm-Potentiometers 10 von einem gemeinsamen Anschluss zweier aufeinanderfolgender Widerstände R5 auf einen anderen gemeinsamen Anschluss zweier aufeinanderfolgender Widerstände R5. Ein digitaler 5Bit-Wert 00000 entspricht vorzugsweise einem Wert N = 31, ein digitaler 5Bit-Wert 00001 einem Wert N = 15 und ein digitaler 5Bit-Wert 11111 einem Wert N = 0. Der zwischen dem Abgriff 10a des Trimm-Potentiometers 10 und dem gemeinsamen Anschluss der Widerstände R3 und R4 gelegene Teil des Widerstandes R4 wird nachfolgend als Trimm-Widerstand $R_{Tr}$ = N.R5 bezeichnet und ist mittels des Abgleichwertes N einstellbar. Dem Trimm-Widerstand $R_{Tr}$ entspricht bei fliessendem Strom $I_v$ eine Trimm-Spannung $U_{Tr} = R_{Tr}.I_v$ = N.R5.$I_v$, mit N = 0 bis 31. Unter Vernachlässigung der Basisströme der Transistoren V1 und V2 gilt somit, unter Berücksichtigung der Gleichungen [VI] und [VII], für die am Abgriff 10a und damit am Ausgang R anstehende Spannung:

$$U_{R,N,T} = U_{be3,T} + U_{R1} + U_{R2} + U_{R3} + U_{Tr}$$

$$= U_{be3,T} + [R1 + R2 + R3 + N.R5].I_v$$

$$= [U_{Gap} - \lambda.T] + [R1 + R2 + R3 + N.R5]. [\Delta U_{be} / R2]$$

$$= [U_{Gap} - \lambda.T] + \{[R1 + R2 + R3 + N.R5] / R2\}.[K.T/q].\ln8$$

Der Temperaturkoeffizient von $U_{R,N,T}$ ist dann:

$$a_{R,N,T} = dU_{R,N,T}/dT = -\lambda + \{[R1 + R2 + R3 + N.R5] / R2\}.[K/q].ln8$$

Die am Abgriff 10a des Trimm-Potentiometers 10 anstehende Referenzspannung $U_{R,N,T}$ und deren Temperaturkoeffizient $a_{R,N,T}$ ist somit mittels des Abgleichwertes N digital einstellbar, was beim Temperaturkoeffizient-Abgleich ausgenutzt wird, indem der Temperaturkoeffizient $a_{R,N,T}$ mit N so programmiert wird, dass Gleichung [V] gilt. Da das Widerstandsverhältnis R1/R2 = 12,5 bereits aus der Berechnung von $dU_Q/dT = 0$ bekannt ist, sind nur noch die Widerstands-Verhältnisse R3/R2 und $R_{Tr}/R2$ = N.R5/R2 zu bestimmen. R3 wird so dimensioniert, dass der Temperaturkoeffizient $a_{R,N,T}$ bei N = 0 den kleinsten zu programmierenden Wert $a_{R,N,Soll,min}$ aufweist. Es gilt dann z. B. [R3 + R1]/R2 = 17,5. Der maximale Trimm-Widerstand $R_{Tr,max}$ = $N_{max}$.R5 = 31.R5 wird so dimensioniert, dass der Temperaturkoeffizient $a_{R,N,T}$ bei N = $N_{max}$ = 31 den grössten zu programmierenden Wert $a_{R,N,Soll,max}$ aufweist. Wenn der digitale Abgleichwert N fünf Bits aufweist, lässt sich für $a_{R,N,T}$ ein Temperaturkoeffizient-Bereich von 600 bis 900 ppm/°K einstellen. Der Abgleich erfolgt dabei vorzugsweise anlässlich des "Wafer"-Tests. Die Referenzspannung $U_{R,N,T}$ wird durch die Programmierung ebenfalls geändert und zwar mit etwa 5,5 mV pro Bit. Z. B. ist bei Raumtemperatur und N = 0 die Referenzspannung $U_{R,N,T}$ annähernd 1,52 Volt und bei N = 31 annähernd 1,69 Volt.

In der Fig. 3 gilt die Annahme, dass die Signalverarbeitungsanordnung 3 als Spannungs/Frequenz-Wandler arbeitet. Sie enthält einen Verstärker 19, dessen beide Gegentaktausgänge auf je einen von zwei Eingängen eines nachgeschalteten Analog/Digital-Wandlers 20 geführt sind, dessen Ausgang über eine Busverbindung mit einem Digitaleingang eines Quantisierers Q verbunden ist. Ein Ausgang des letzteren bildet einen Ausgang der Signalverarbeitungsanordnung 3, der gleichzeitig ein Ausgang des Energie- und/oder Leistungs-Messgerätes 1 ist. Ein nichtinvertierender Eingang des Verstärkers 19 bildet den Eingang D der Signalverarbeitungsanordnung 3, der gleichzeitig der Eingang E des Energie- und/oder Leistungs-Messgerätes 1 ist. Der Eingang D ist mit dem Ausgang des Sensors 2 verbunden, während ein invertierender Eingang des Verstärkers 19 an Masse liegt. Die von der Referenzspannungsquelle 4 gelieferte Referenzspannung $U_{R,N,T}$ ist auf einen Referenzsignaleingang des Analog/Digital-Wandlers 20 geführt. Die Referenzspannungsquelle 4 ist räumlich so angeordnet, dass sie im Betrieb die gleiche Temperatur besitzt wie der Sensor 2 und die Signalverarbeitungsanordnung 3. Der Referenzfrequenzgenerator 5, z. B. ein Quarzoszillator, speist, wie bereits erwähnt, den zweiten Referenzsignaleingang der Signalverarbeitungsanordnung 3 mit dem Taktsignal der Frequenz $f_R$. Die beiden Ausgangssignale des Verstärkers 19 sind leistungsproportional und gleich +k.p[t] bzw. -k.p[t], wenn k eine Proportionalitätskonstante darstellt. Am Ausgang des Analog/Digital-Wandlers 20 sind digitalisierte Werte der gemittelten Leistungssignale +k.p[t] und -kp[t] vorhanden, welche Werte z. B. 22 Bits aufweisen und im Quantisierer Q quantisiert werden, d. h. fortwährend aufsummiert (akkumuliert) und in konstanten Quanten zerlegt werden. Jedesmal wenn die Summe im Akkumulator einen bestimmten Wert überschreitet, wird von der Summe eine konstante Zahl (Quantum) abgezogen und gleichzeitig am Ausgang des Quantisierers Q ein Ausgangsimpuls erzeugt. Diese Ausgangsimpulse besitzen die mittlere Frequenz $\overline{f_{N,T}}$, die vom Abgleichwert N und von der Temperatur T abhängig ist.

Ein externer Computer 22 , vorzugsweise ein Mikrocomputer, ist über eine Schnittstellen-Busverbindung 23 mit dem Energie- und/oder Leistungs-Messgerät 1, genauer ausgedrückt mit einer dort vorhandenen Schnittstellen-Logik 24 verbunden. Die Schnittstellen-Busverbindung 23 und die Schnittstellen-Logik 24 bilden zusammen eine serielle Kommunikations-Schnittstelle 23;24, welche vorzugsweise eine normierte Schnittstelle ist. In diesem Fall enthält die Schnittstellen-Busverbindung 23 z. B. einen Leiter 25 zur Übertragung eines Datensignals MOSI ("Master Out, Slave In"), einen Leiter 26 zur Übertragung eines Schnittstellen-Freigabesignals ENI ("Enable Interface"), einen Leiter 27 zur Übertragung eines Schnittstellen-Taktsignals SCK und einen Leiter 28 zur Übertragung eines Programmierimpulses PRG jeweils vom Computer 22 zum Messgerät 1. Dabei ist der Computer 22 ein "Master" und das Messgerät 1 ein "Slave". Das Datensignal MOSI besitzt z. B. 32 Bits, wovon fünf Bits, z. B das vierzehnte bis achtzehnte Bit, die fünf Bits des digitalen Abgleichwertes N sind. Ausserdem enthält das Datensignal MOSI noch Bitwerte von mindestens drei weiteren Bits TPRG, TPTC und BTK, z. B. als erstes bzw. zehntes bzw. dreizehntes Bit. Die Schnittstellen-Logik 24 enthält ein Schieberegister 29, eine Programmierungs-Freigabeanordnung 30 und einen mit Start- und Stopp-Logik versehenen Zähler 33. Das Schieberegister 29 besitzt ebensoviele Bits, nämlich 32 Bits, wie das Datensignal MOSI. Das letztere ist über den Leiter 25 auf einen seriellen Eingang IN des Schieberegisters 29 geführt. Das Schnittstellen-Taktsignal SCK speist über den Leiter 27 und den Zähler 33 einen Takteingang des Schieberegisters 29. Die fünf zu den fünf Bits des digitalen Abgleichwertes N gehörenden Parallelausgänge des Schieberegisters 29 sind über eine Busverbindung 34 mit einem Buseingang der Programmierungs-Freigabeanordnung 30 sowie mit einem Buseingang eines ersten Hilfsspeichers 35 verbunden. Das Schnittstellen-Freigabesignal ENI ist über den Leiter 26 auf einen Freigabeeingang des Schieberegisters 29 und einen Rückstelleingang des ersten Hilfsspeichers 35 geführt. Die zu den Bits TPRG und TPTC gehörenden Ausgänge des Schieberegisters 29 sind je auf einen Eingang einer zugehörigen Speicherzelle eines zweiten Hilfsspeichers 36 geführt, deren Ausgangssignal TM1 bzw. TM10 ist. Vor dem Programmieren des Wertes N besitzt das Signal ENI, welches vom Computer 22 dem Messgerät 1 zugeleitet wird, einen Logikwert "0", welcher das Messgerät 1 auf Null zurückgestellt. Die Signale TM1 und TM10 sind dann beide Null. Zu Beginn des Programmierens setzt der Computer 22 das Signal ENI auf Logikwert "1", wodurch die Bauelemente 29 und 33 freigegeben werden und der Zählvorgang des Zählers 33 gestartet wird. Die Kommunikations-Schnittstelle 23; 24 empfängt zeitseriell die Bits des Datensignals MOSI und schiebt diese mit Hilfe des Schnittstellen-Taktsignals SCK in das Schieberegister 29, wo sie zwischengespeichert werden. Der Zähler 33 zählt ab Startaugenblick die Perioden des durch die Start-Logik freigegebenen Schnittstellen-Taktsignals SCK und erzeugt an einem seiner Ausgänge einen Impuls, wenn das Datensignal MOSI in das Schieberegister 29 hineingeschoben ist. Dieser Impuls erreicht einen Ladeeingang LD des ersten Hilfsspeichers 35, wo er veranlasst, dass die fünf Bits des digitalen Abgleichwertes N aus dem Schieberegister 29 in den Hilfsspeicher 35 geladen werden, und einen Takteingang eines zweiten Hilfsspeichers 36, wo er veranlasst, dass die Werte der Bits TPRG und TPTC aus dem Schieberegister 29 in ihre zugehörige Speicherzelle des Hilfsspeichers 36 geladen werden. Ein Mehrbit-Umschalter 37 ist vorhanden zwecks eines Umschaltens des Programmier-Buseingangs 13 der Referenzspannungsquelle 4 von einem Busausgang 38a eines Speichers 38, der vorzugsweise ein unverlierbarer Speicher ist, auf einen Busausgang des ersten Hilfsspeichers 35. Zu diesem Zweck ist der letztere Busausgang über eine Busverbindung 39 auf fünf erste Eingänge des Mehrbit-Umschalters 37 geführt, während der Busausgang 38a des Speichers 38 über eine Busverbindung 40 mit fünf zweiten Eingängen des Mehrbit-Umschalters 37 verbunden ist, dessen Ausgang über eine Busverbindung 41 auf den Programmier-Buseingang 13 der Referenzspannungsquelle 4 geführt ist. Das Signal TM10 speist einen Steuereingang des Mehrbit-Umschalters 37. Der Speicher 38 ist vorzugsweise ein feldprogrammierbarer Festwertspeicher FPROM ("Field programmable Read Only Memory") oder ein elektrisch programmierbarer Festwertspeicher EEPROM ("Electrical Erasable Programmable Read Only Memory"). Die Programmierungs-Freigabeanordnung 30 enthält ein Freigabe-Gatter 30a mehr als N Anzahl Bits aufweist, nämlich ein sechstes Freigabe-Gatter 30a für eine zugehörige Speicherzelle des Speichers 38 zwecks dortigem Speichern des im Schieberegister 29 zwischengespeicherten Bits BTK, welches ein Sperr-Bit ist. Alle Freigabe-Gatter 30a sind z. B. Und-Gatter. Ein zum Bit BTK gehörender Parallelausgang des Schieberegisters 29 ist mit einem ersten Eingang des sechsten Freigabe-Gatters 30a der Programmierungs-Freigabeanordnung 30 verbunden, dessen zweiter Eingang mit einem Ausgang eines Und-Gatters 42 und einem ersten Eingang eines Sperr-Gatters 43 verbunden ist, während sein Ausgang mit einem Eingang der zusätzlichen zugehörigen Speicherzelle des Speichers 38 verbunden ist. Ein Ausgang der letzteren ist über einen Inverter 44 mit einem zweiten Eingang des Sperr-Gatters 43 verbunden zwecks Sperrung der fünf anderen Freigabe-Gatter 30a der Programmierungs-Freigabeanordnung 30. Zu diesem Zweck ist der Ausgang des Sperr-Gatters 43 mit einem Programmier-Eingang 30b der Programmierungs-Freigabeanordnung 30 verbunden. Die ersten Eingängen der fünf anderen Freigabe-Gatter 30a der Programmierungs-Freigabeanordnung 30 bilden den Buseingang der letzteren, während die zweiten Eingänge dieser fünf Freigabe-Gatter 30a alle miteinander verbunden den Programmier-Eingang 30b der Programmierungs-Freigabeanordnung 30 bilden. Die Ausgänge der fünf Freigabe-Gatter 30a bilden den Busausgang der Programmierungs-Freigabeanordnung 30, der über eine Busverbindung mit einem Buseingang des Speichers 38 verbunden ist. Die Programmierungs-Freigabeanordnung 30 dient somit der Weiterleitung der Werte der fünf Bits von N sowie desjenigen des Sperr-Bits BTK an den Speicher 38 zwecks dortiger Speicherung. Der Computer 22 speist über den Leiter 28 einen ersten Eingang des Und-Gatters 42 mit dem Programmierimpuls PRG. Am zweiten Eingang des Und-Gatters 42 liegt das Signal TM1. Das Sperr-Gatter 43 ist z. B. ein Und-Gatter.

Wenn der Wert N nur vorübergehend gespeichert werden soll und zwar in den Hilfsspeicher 35, besitzen das Bit TPRG und das Signal TM1 je einen Logikwert "0" sowie das Bit TPTC und das Signal TM10 je einen Logikwert "1". Der letztere schaltet den Mehrbit-Umschalters 37 um, während das Signal TM1 das Und-Gatter 42 sperrt. Der Busausgang des Hilfsspeichers 35 ist dann über den umgeschalteten Mehrbit-Umschalter 37 mit dem Programmier-Buseingang 13 der Referenzspannungsquelle 4 verbunden. Die letztere und damit auch das Messgerät 1 arbeiten mit dem im Hilfsspeicher 35 vorübergehend gespeicherten Wert N. Wenn der Wert N dagegen definitiv in den unverlierbaren Speicher 38 gespeichert werden soll, besitzt das Bit TPRG und das Signal TM1 je einen Logikwert "1" sowie das Bit TPTC und das Signal TM10 je einen Logikwert "0". Das Signal TM1 gibt das Und-Gatter 42 frei und der Mehrbit-Umschalter 37 wird nicht umgeschaltet. Der Busausgang des unverlierbaren Speichers 38 ist somit mit dem Programmier-Buseingang 13 der Referenzspannungsquelle 4 verbunden. Nachdem der Logikwert "1" des Signals TM1 das Und-Gatter 42 freigegeben hat, sendet der Computer 22 über den Leiter 28 einen kurzen Programmierimpuls PRG, z. B. der Dauer 10μs, welcher über die Gatter 42 und 43 die zweite Eingänge der Freigabe-Gatter 30a der Programmier-Freigabeanordnung 30 erreicht, wodurch die angeschlossenen Freigabe-Gatter 30a für die Dauer des Programmierimpulses freigegeben werden. Dadurch werden die fünf Bits des Wertes N in den Speicher 38 geladen, von wo sie über den nicht umgeschalteten Mehrbit-Umschalter 37 den Programmier-Buseingang 13 der Referenzspannungsquelle 4 erreichen. Die letztere und damit auch das Messgerät 1 arbeiten in diesem Fall mit dem im Speicher 38 definitiv unverlierbar gespeicherten Abgleichwert N. Am Ende der Programmierung beendet der Computer 22 diese jeweils, indem er das Signal ENI auf Null zurückschaltet, wodurch das Messgerät 1 auf Null zurückgestellt wird, so dass unter anderem das Und-Gatter 42 wieder für jeden weiteren Programmierimpuls PRG gesperrt wird.

Wenn nach dem Programmieren der im Speicher 38 unverlierbar gespeicherte Abgleichwert N als korrekt empfunden wird, muss er unwiderruflich definitiv gemacht werden, damit er später absichtlich oder unabsichtlich nicht mehr geändert werden kann. Zu diesem Zweck wird in einem Programmier-Abschlussmodus ein einzelner Programmierzyklus durchgeführt, um ein Logikwert "1" des Sperr-Bits BTK in den Speicher 38 zu speichern. Im Programmier-Abschlussmodus werden, nachdem der Wert N im Speicher 38 gespeichert ist, das Signal MOSI, das Schnittstellen-Taktsignal SCK, das Schnittstellen-Freigabesignal ENI sowie der Programmierimpuls PRG vom Computer 22 dem Messgerät 1 zugeführt. Die fünf zum Abgleichwert N gehörenden Bits sowie das Bit TPTC des vom Computer 22 gesandten Signals MOSI besitzen dabei je einen Logikwert "0", während die Bits TPRG und BTK je einen Logikwert "1" aufweisen. Das Speichern des Bits BTK in den Speicher 38 erfolgt auf die gleiche Weise wie das Speichern der Bits des Abgleichwertes N. Der vom Computer 22 gesandte kurze Programmierimpuls PRG gibt unter anderem das zum Sperr-Bit BTK gehörende sechste Freigabe-Gatter 30a der Programmier-Freigabeanordnung 30 für die Dauer des Programmierimpulses frei. Dadurch wird die zum Sperr-Bit BTK gehörende Speicherzelle des Speichers 38 programmiert und dort ein Logikwert "1" gespeichert bzw. eingebrannt. Das im Speicher 38 gespeicherte Sperr-Bit BTK wird schliesslich verwendet, um definitif ein weiteres Laden des Speichers 38 zu verhindern, indem sein Logikwert "1" über den Inverter 44 das Sperr-Gatter 43 für immer sperrt. Dadurch kann in Zukunft definitiv kein Programmierimpuls PRG mehr den Programmier-Eingang 30b erreichen und kann somit der Inhalt des Speichers 38 auch nicht mehr geändert werden. Der Computer 22 beendet den Programmier-Abschlussmodus, indem er das Signal ENI auf Null zurücksetzt, wodurch das Messgerät 1 auf Null zurückgestellt wird. Wenn das Messgerät 1 definitiv programmiert ist, kann das Messgerät 1 aus der Programmier-Einrichtung entfernt und temperaturkompensiert weiter verwendet werden.

Während des Programmierens ist der Ausgang 1a des Messgerätes 1, an dem die Referenzspannung $U_{R,N,T}$ ansteht, mit einem Eingang eines Spannungs-Messgerätes 45 verbunden, welches somit die Referenzspannung $U_{R,N,T}$ misst. Der Ausgang des Quantisierers Q ist mit einem Eingang eines weiteren Messgerätes 46 verbunden, welches im Beispiel der Fig. 3 ein Frequenz-Messgerät ist und die mittlere Frequenz $\overline{f_{N,T}}$ misst. Je ein digitaler Busausgang der Messgeräte 45 und 46 ist auf ein Port C bzw. D des Computers 22 geführt.

Mit z. B. Zweitemperatur-Messungen werden zeitlich nacheinander, in der angegebenen Reihenfolge, die nachfolgend aufgelisteten Parameter gemessen beziehungsweise vom Computer 22 berechnet, wobei alle gemessenen und berechneten Werte jeweils in den Computer 22 gespeichert werden:

- Die temperaturabhängige Referenzspannung $U_{R,N,T}$ wird bei der Referenztemperatur, z. B. $T_0 = 35\,°C$, mit einem ersten Abgleichwert, z. B. einem minimalen Abgleichwert N = 0, und einem zweiten Abgleichwert, z. B. einem maximalen Abgleichwert N = 31, gemessen, wobei der gemessene Wert jeweils $U_{R,0,35}$ bzw. $U_{R,31,35}$ ist.

- Die temperaturabhängige Referenzspannung $U_{R,N,T}$ wird bei einer zweiten Temperatur, z. B. $T_1 = 85\,°C$, mit dem ersten Abgleichwert N = 0 und dem zweiten Abgleichwert N = 31 gemessen, wobei der gemessene Wert jeweils $U_{R,0,85}$ bzw. $U_{R,31,85}$ ist.

- Ein Wert des absoluten Temperaturkoeffizienten $a_{R,N}$ der temperaturabhängigen Referenzspannung $U_{R,N,T}$ wird beim ersten Abgleichwert N = 0 und beim zweiten Abgleichwert N = 31 mittels einer Formel

$$a_{R,31} = [U_{R,31,85} - U_{R,31,35}] / \Delta T \text{ bzw.}$$

$$a_{R,0} = [U_{R,0,85} - U_{R,0,35}] / \Delta T$$

berechnet, da:

$$U_{R,N,85} = U_{R,N,35} + a_{R,N}.\Delta T \qquad\qquad (siehe[IV])$$

- Zwei Parameter $\Delta a_R$ und $\Delta U_{R,35}$ werden mittels nachfolgender Formeln

$$\Delta a_R = [a_{R,31} - a_{R,0}] / \Delta N \qquad\qquad [VIII]$$

und

$$\Delta U_{R,35} = [U_{R,31,35} - U_{R,0,35}] / \Delta N \qquad\qquad [IX]$$

berechnet.

Dabei sind:

$\Delta N = N = 31$ die Differenz der beiden Abgleichwerte $N = 31$ und $N = 0$,

$a_{R,31}$ und $a_{R,0}$ zwei Werte des absoluten Temperaturkoeffizienten $a_{R,N}$ der temperaturabhängigen Referenzspannung $U_{R,N,T}$ beim zweiten Abgleichwerten $N = 31$ bzw. beim ersten Abgleichwert $N = 0$, sowie

$U_{R,31,35}$ und $U_{R,0,35}$ zwei bei der Referenztemperatur $T_0 = 35°C$ und dem zweiten Abgleichwert $N = 31$ bzw. ersten Abgleichwert $N = 0$ gemessene Werte der temperaturabhängigen Referenzspannung $U_{R,N,T}$.

Der Parameter $\Delta a_R$ stellt die Neigung der als linear angenommenen Kennlinie $a_{R,N} = a_{R,0} + \Delta a_R . \Delta N$ des absoluten Temperaturkoeffizienten $a_{R,N}$ in Funktion des Abgleichwertes $N = \Delta N$ dar, während der Parameter $\Delta U_{R,35}$ die Neigung der als linear angenommenen Kennlinie der Referenzspannung $U_{R,N,35}$ in Funktion des Abgleichwertes $N$ darstellt.

- Ein zur Temperaturkompensation erforderlicher Wert des Abgleichwertes $N$ ist gleich einem auf eine ganze Zahl abgerundeten Wert von

$$N_K = [a_{R,0} - \alpha_{R,N,Soll} \cdot U_{R,0,35}] / [\alpha_{R,N,Soll} \cdot \Delta U_{R,35} - \Delta a_R] \qquad [X]$$

Der Wert $N_K$ wird daher mittels dieser Formel berechnet und der berechnete Wert $N_K$ anschliessend, auf eine ganze Zahl abgerundet, in den Computer 22 gespeichert. Der abgerundete Wert von $N_K$ muss im angenommenen Beispiel zwischen 0 und 31 liegen.

Die Formel [X] ergibt sich, mit $\Delta N = N$, aus der Auflösung nach $N$ der Gleichungen

$$\alpha_{R,N,Soll} = \alpha_{R,N} = a_{R,N} / U_{R,N,35} \qquad \text{(siehe [IVa])}$$

$$\text{mit } a_{R,31} = a_{R,0} + \Delta N . \Delta a_R \qquad \text{(siehe [VIII])}$$

$$\text{und } U_{R,31,35} = U_{R,0,35} + \Delta N . \Delta U_{R,35} \qquad \text{(siehe [IX])}$$

Während der Messungen werden jeweils einer der Abgleichwerte $N = 0$ oder $N = 31$ als Teil des Signals MOSI vom Computer 22 über die Kommunikations-Schnittstelle 23;24 zum Messgerät 1 übertragen, wo der betreffende Wert von $N$ vorübergehend in den Hilfsspeicher 35 gespeichert wird, um über den mittels des Signals TM10 umgeschalteten Mehrbit-Umschalter 37 dem Programmier-Buseingang 13 der Referenzspannungsquelle 4 zugeführt zu werden. Während der Messungen steht somit jeweils der erste oder zweite Abgleichwert am Programmier-Buseingang 13 an. Die Messgeräte 45 und 46 messen dann die Werte $U_{R,0,35}$, $U_{R,31,35}$, $U_{R,0,85}$ und $U_{R,31,85}$ bzw. $\overline{f_{0,35}}$ und $\overline{f_{0,85}}$. Die gemessenen Werte erreichen über das Port C bzw. D jeweils den Computer 22, wo sie gespeichert und zu Rechenzwecken weiter verwendet werden. Die Berechnungen und der Abgleich erfolgen jeweils vorzugsweise bei der Referenztemperatur $T_0 = 35°C$.

**Patentansprüche**

**1.** Anordnung zur Temperaturkompensation eines temperaturabhängigen Übertragungsfaktors ($K_{H,T} . K_{S,T}$) eines Sensors (2) und einer nachgeschalteten Signalverarbeitungsanordnung (3), vorzugsweise eines Energie- und/oder Leistungs-Messgerätes (1), **dadurch gekennzeichnet, dass** ein Übertragungsfaktor ($K_{S,T}$ bzw. $K_{F,T}$ bzw. $K_{A,T}$) der Signalverarbeitungsanordnung (3) umgekehrt proportional einer temperaturabhängigen Referenzspannung ($U_{R,N,T}$) einer Referenzspannungsquelle (4) ist, welche räumlich so nahe beim Sensor (2) und der Signalverarbeitungsanordnung (3) angeordnet ist, dass sie im Betrieb die gleiche Temperatur (T) aufweist wie die beiden letzteren, und dass ein Wert ($\alpha_{R,N,Soll}$) eines Temperaturkoeffizienten ($\alpha_{R,N}$) der temperaturabhängigen Referenzspannung ($U_{R,N,T}$) gleich ist der Summe eines Temperaturkoeffizienten ($\alpha_H$) des Übertragungsfaktors ($K_{H,T}$) des Sensors (2) und eines Temperaturkoeffizienten ($\alpha_F$ bzw. $\alpha_A$) des Übertragungsfaktors ($K_{S,T}$ bzw. $K_{F,T}$ bzw. $K_{A,T}$) der nichttemperaturkompensierten Signalverarbeitungsanordnung (3).

**2.** Anordnung nach Anspruch 1, **dadurch gekennzeichnet, dass** der Wert ($\alpha_{R,N,Soll}$) des Temperaturkoeffizienten ($\alpha_{R,N}$) der temperaturabhängigen Referenzspannung ($U_{R,N,T}$) programmierbar ist.

**3.** Anordnung nach Anspruch 1 oder 2, **dadurch gekennzeichnet, dass** der Wert ($\alpha_{R,N,Soll}$) des Temperaturkoeffizienten ($\alpha_{R,N}$) der temperaturabhängigen Referenzspannung ($U_{R,N,T}$) mittels eines in einem Speicher (38) der Anordnung unverlierbar gespeicherten Abgleichwertes (N) programmierbar ist.

**4.** Anordnung nach einem der Ansprüche 1 bis 3, **dadurch gekennzeichnet, dass** in der Referenzspannungsquelle (4) ein negativer Temperaturkoeffizient einer Basis/Emitter-Spannung ($U_{be3,T}$) eines ersten Transistors (V3) und ein positiver Temperaturkoeffizient eines in einem Polysilizium-Halbleiterwiderstand (R1;R2;R3;R4) mittels eines einen positiven Temperaturkoeffizienten aufweisenden Stromes ($I_v$) erzeugten Spannungsabfalls so miteinander kombiniert sind, dass die temperaturabhängige Referenzspannung ($U_{R,N,T}$) den Wert ($\alpha_{R,N,Soll}$) des Temperaturkoeffizienten ($\alpha_{R,N}$) besitzt.

**5.** Anordnung nach Anspruch 4, **dadurch gekennzeichnet,**

- **dass** der den positiven Temperaturkoeffizienten aufweisende Strom ($I_v$) aus einer Differenz ($\Delta U_{be}$) von Basis/Emitter-Spannungen ($U_{be1}$, $U_{be2}$) zweier weiterer, mit unterschiedlichen Stromdichten ($I_{C1}/A_1$, $I_{C2}/A_2$) in Differenzschaltung betriebenen Transistoren (V1, V2) erzeugt ist, deren beide miteinander verbundenen Emitter von einer gemeinsamen ersten Stromquelle (8) gespeist sind,
- **dass** eine zweite Stromquelle (9) einen ersten Widerstand (R2) speist, dessen beide Anschlüsse mit je einer Basis der beiden weiteren Transistoren (V1, V2) verbunden sind, und
- **dass** die beiden Stromquellen (8, 9) so miteinander gekoppelt sind, dass ihre beiden Ströme ($2I_f$, $I_v$) proportional zueinander sind und der Strom der zweiten Stromquelle (9) der den positiven Temperaturkoeffizienten aufweisende Strom ($I_v$) ist.

**6.** Anordnung nach Anspruch 5, **dadurch gekennzeichnet, dass** eine die Basis/Emitter-Spannung ($U_{be3,T}$) aufweisende Basis/Emitter-Strecke des ersten Transistors (V3), der Polysilizium-Halbleiterwiderstand (R1;R2;R3;R4) und die zweite Stromquelle (9) in der angegebenen Reihenfolge elektrisch in Reihe geschaltet sind und der Polysilizium-Halbleiterwiderstand (R1;R2;R3:R4) mehrere elektrisch in Reihe geschaltete Widerstände (R1,R2,R3,R4) enthält, darunter den ersten Widerstand (R2).

**7.** Anordnung nach Anspruch 6, **dadurch gekennzeichnet, dass** ein zweiter und ein dritter Widerstand (R3, R4) der im Polysilizium-Halbleiterwiderstand (R1;R2;R3;R4) enthaltenen Widerstände in der Reihenschaltung zwischen der zweiten Stromquelle (9) und dem ersten Widerstand (R2) angeordnet sind.

**8.** Anordnung nach Anspruch 7, **dadurch gekennzeichnet, dass** der dritte Widerstand (R4) ein Gesamtwiderstand eines Trimm-Potentiometers (10) ist, an dessen Abgriff (10a) im Betrieb die temperaturabhängige Referenzspannung ($U_{R,N,T}$) ansteht, und dass der dritte Widerstand (R4) in der Reihenschaltung zwischen dem zweiten Widerstand (R3) und der zweiten Stromquelle (9) angeordnet ist.

**9.** Anordnung nach Anspruch 8, **dadurch gekennzeichnet, dass** das Trimm-Potentiometer (10) ein digitales Potentiometer ist, dessen Trimm-Widerstand ($R_{Tr}$ =N.R5) mittels eines Abgleichwertes (N) einstellbar ist.

**10.** Anordnung nach einem der Ansprüche 6 bis 9, **dadurch gekennzeichnet, dass** zur Erzeugung einer temperaturunabhängigen Referenzspannung ($U_Q$) ein vierter Widerstand (R1) der im Polysilizium-Halbleiterwiderstand (R1;R2;R3;R4) enthaltenen Widerstände in der Reihenschaltung zwischen der Basis/Emitter-Strecke des ersten Transistors (V3) und dem ersten Widerstand (R2) angeordnet ist.

**11.** Anordnung nach einem der Ansprüche 1 bis 10, **dadurch gekennzeichnet, dass** ein Wert eines Abgleichwertes (N) gleich ist einem auf eine ganze Zahl abgerundeten Wert von

$$N_K = [a_{R,0} - \alpha_{R,N,Soll} \cdot U_{R,0,35}] / [\alpha_{R,N,Soll} \cdot \Delta U_{R,35} - \Delta a_R]$$

mit

- $\alpha_{R,N,Soll}$ : Wert des Temperaturkoeffizienten ($\alpha_{R,N}$) der temperaturabhängigen Referenzspannung ($U_{R,N,T}$),

- $U_{R,0,35}$ : bei einer Referenztemperatur ($T_0$) und einem ersten Abgleichwert ($N_1$) gemessener Wert der temperaturabhängigen Referenzspannung ($U_{R,N,T}$),
- $U_{R,31,35}$ : bei der Referenztemperatur ($T_0$) und einem zweiten Abgleichwert ($N_2$) gemessener Wert der temperaturabhängigen Referenzspannung ($U_{R,N,T}$),
- $U_{R,0,85}$ : bei einer zweiten Temperatur ($T_1$) und dem ersten Abgleichwert ($N_1$) gemessener Wert der temperaturabhängigen Referenzspannung ($U_{R,N,T}$),
- $U_{R,31,85}$ : bei der zweiten Temperatur ($T_1$) und dem zweiten Abgleichwert ($N_2$) gemessener Wert der temperaturabhängigen Referenzspannung ($U_{R,N,T}$),
- $a_{R,0} = [U_{R,0,85} - U_{R,0,35}]/\Delta T$,
- $a_{R,31} = [U_{R,31,85} - U_{R,31,35}]/\Delta T$,
- $\Delta a_R = [a_{R,31} - a_{R,0}] / \Delta N$,
- $\Delta U_{R,35} = [U_{R,31,35} - U_{R,0,35}] / \Delta N$,
- $\Delta N$ : Differenz der beiden Abgleichwerte ($N_2$, $N_1$) und
- $\Delta T$ : Differenz ($T_1 - T_0$) der beiden Temperaturen ($T_1$, $T_0$).

**Claims**

1. An arrangement for temperature compensation of a temperature-dependent transmission factor ($K_{H,T}.K_{S,T}$) of a sensor (2) and a signal processing arrangement (3) connected on the output side thereof, preferably an energy and/or power measuring apparatus (1), **characterised in that** a transmission factor ($K_{S,T}$ or $K_{F,T}$ or $K_{A,T}$) of the signal processing arrangement (3) is inversely proportional to a temperature-dependent reference voltage ($U_{R,N,T}$) of a reference voltage source (4) which is spatially arranged so close to the sensor (2) and the signal processing arrangement (3) that in operation it is at the same temperature (T) as the latter two, and that a value ($\alpha_{R,N,Ref}$) of a temperature coefficient ($\alpha_{R,N}$) of the temperature-dependent reference voltage ($U_{R,N,T}$) is equal to the sum of a temperature coefficient ($\alpha_H$) of the transmission factor ($K_{H,T}$) of the sensor (2) and a temperature coefficient ($\alpha_F$ or $\alpha_A$) of the transmission factor ($K_{S,T}$ or $K_{F,T}$ or $K_{A,T}$) of the signal processing arrangement (3) which is not temperature-compensated.

2. An arrangement according to claim 1 **characterised in that** the value ($\alpha_{R,N,Ref}$) of the temperature coefficient ($\alpha_{R,N}$) of the temperature-dependent reference voltage ($U_{R,N,T}$) is programmable.

3. An arrangement according to claim 1 or claim 2 **characterised in that** the value ($\alpha_{R,N,Ref}$) of the temperature coefficient ($\alpha_{R,N}$) of the temperature-dependent reference voltage ($U_{R,N,T}$) is programmable by means of an adjustment value (N) which is stored in non-volatile manner in a memory (38) of the arrangement .

4. An arrangement according to one of claims 1 to 3 **characterised in that** in the reference voltage source (4) a negative temperature coefficient of a base/emitter voltage ($U_{be3,T}$) of a first transistor (V3) and a positive temperature coefficient of a voltage drop produced in a polysilicon semiconductor resistor (R1;R2;R3;R4) by means of a current ($I_v$) having a positive temperature coefficient are so combined with each other that the temperature-dependent reference voltage ($U_{R,N,T}$) is of the value ($\alpha_{R,N,Ref}$) of the temperature coefficient ($\alpha_{R,N}$).

5. An arrangement according to claim 4 **characterised in that**

- the current ($I_V$) involving the positive temperature coefficient is produced from a difference ($\Delta U_{be}$) of base/emitter voltages ($U_{be1}$, $U_{be2}$) of two further transistors (V1, V2) which are operated with different current densities ($I_{C1}/A_1$, $I_{C2}/A_2$) in a differential circuit and whose two interconnected emitters are fed by a common first current source (8),
- a second current source (9) feeds a first resistor (R2) whose two terminals are connected to a respective base of the two further transistors (V1, V2), and
- the two current sources (8, 9) are so coupled together that their two currents ($2I_f$, $I_v$) are proportional to each other and the current of the second current source (9) is the current ($I_v$) involving the positive temperature coefficient.

6. An arrangement according to claim 5 **characterised in that** a base/emitter path of the first transistor (V3) having the base/emitter voltage ($U_{be3,T}$), the polysilicon semiconductor resistor (R1;R2;R3;R4) and the second current source (9) are electrically connected in series in the specified sequence and the polysilicon semiconductor resistor (R1;R2;R3;R4) includes a plurality of resistors (R1,R2,R3,R4) which are electrically connected in series, including therein the first resistor (R2).

7. An arrangement according to claim 6 **characterised in that** a second and a third resistor (R3, R4) of the resistors contained in the polysilicon semiconductor resistor (R1;R2;R3;R4) are arranged in the series circuit between the second current source (9) and first resistor (R2).

8. An arrangement according to claim 7 **characterised in that** the third resistor (R4) is an overall resistor of a trimming potentiometer (10), at the tapping (10a) of which occurs in operation the temperature-dependent reference voltage ($U_{R,N,T}$), and that the third resistor (R4) is arranged in the series circuit between the second resistor (R3) and the second current source (9).

9. An arrangement according to claim 8 **characterised in that** the trimming potentiometer (10) is a digital potentiometer whose trimming resistor ($R_{Tr} = N \cdot R5$) can be set by means of an adjustment value (N).

10. An arrangement according to one of claims 6 to 9 **characterised in that** to produce a temperature-independent reference voltage ($U_Q$) a fourth resistor (R1) of the resistors contained in the polysilicon semiconductor resistor (R1;R2;R3;R4) is arranged in the series circuit between the base/emitter path of the first transistor (V3) and first resistor (R2).

11. An arrangement according to one of claims 1 to 10 **characterised in that** a value of an adjustment value (N) is equal to a value, rounded off to a whole number, of

$$N_K = [a_{R,0} - \alpha_{R,N,Ref} \cdot U_{R,0,35}] / [\alpha_{R,N,Ref} \cdot \Delta U_{R,35} - \Delta a_R]$$

with

- $\alpha_{R,N,Ref}$: the value of the temperature coefficient ($\alpha_{R,N}$) of the temperature-dependent reference voltage ($U_{R,N,T}$),
- $U_{R,0,35}$: the value of the temperature-dependent reference voltage ($U_{R,N,T}$), measured at a reference temperature ($T_0$) and with a first adjustment value ($N_1$),
- $U_{R,31,35}$: the value of the temperature-dependent reference voltage ($U_{R,N,T}$), measured at the reference temperature ($T_0$) and with a second adjustment value ($N_2$),
- $U_{R,0,85}$: the value of the temperature-dependent reference voltage ($U_{R,N,T}$), measured at a second temperature ($T_1$) and with the first adjustment value ($N_1$),
- $U_{R,31,85}$: the value of the temperature-dependent reference voltage ($U_{R,N,T}$), measured at the second temperature ($T_1$) and with the second adjustment value ($N_2$),
- $a_{R,0} = [U_{R,0,85} - U_{R,0,35}]/\Delta T$,
- $a_{R,31} = [U_{R,31,85} - U_{R,31,35}]/\Delta T$,
- $\Delta a_R = [a_{R,31} - a_{R,0}] / \Delta N$,
- $\Delta U_{R,35} = [U_{R,31,35} - U_{R,0,35}] / \Delta N$,
- $\Delta N$: the difference between the two adjustment values ($N_2$, $N_1$), and
- $\Delta T$: the difference ($T_1 - T_0$) between the two temperatures ($T_1$, $T_0$).

**Revendications**

1. Dispositif de compensation de température d'un facteur de transmission ($K_{H,T}$. $K_{S,T}$), fonction de la température, d'un détecteur (2) et d'un dispositif de traitement du signal (3) monté en aval, de préférence d'un appareil de mesure de l'énergie et/ou de la puissance (1), **caractérisé par le fait qu'**un facteur de transmission ($K_{S,T}$ ou $K_{F,T}$ ou $K_{A,T}$) du dispositif de traitement du signal (3) est inversement proportionnel à une tension de référence ($U_{R,N,T}$), d'une source de tension de référence (4), qui est disposée, dans l'espace, suffisamment près du détecteur (2) et du dispositif de traitement du signal (3) pour présenter en service la même température (T) que les deux derniers et **par le fait qu'**une valeur ($\alpha_{R,N,presc}$) d'un coefficient de température ($\alpha_{R,N}$) de la tension de référence ($U_{R,N,T}$) fonction de la température est égal à la somme d'un coefficient de température ($\alpha_H$) du facteur de transmission ($K_{H,T}$) du détecteur (2) et d'un coefficient de température ($\alpha_F$ ou $\alpha_A$) du facteur de transmission ($K_{S,T}$ ou $K_{F,T}$ ou $K_{A,T}$) du dispositif de traitement du signal (3) non compensé en température.

**2.** Dispositif selon la revendication 1, **caractérisé par le fait que** la valeur ($\alpha_{R,N,presc}$) du coefficient de température ($\alpha_{R,N}$) de la tension de référence ($U_{R,N,T}$) fonction de la température est programmable.

**3.** Dispositif selon la revendication 1 ou 2, **caractérisé par le fait que** la valeur ($\alpha_{R,N,presc}$) du coefficient de température ($\alpha_{R,N}$) de la tension de référence ($U_{R,N,T}$) fonction de la température est programmable au moyen d'une valeur d'alignement (N) mémorisée, de façon imperdable, dans une mémoire (38) du dispositif.

**4.** Dispositif selon l'une des revendications 1 à 3, **caractérisé par le fait que** dans la source de tension de référence (4), un coefficient de température négatif d'une tension base/émetteur ($U_{be3,T}$) d'un premier transistor (V3) et un coefficient de température positif d'une chute de tension produite, dans une résistance à semiconducteur en polysilicium ($R_1$, $R_2$, $R_3$, $R_4$), au moyen d'une intensité (Iv) présentant un coefficient de température positif sont combinés l'un à l'autre de façon que la tension de référence ($U_{R,N,T}$) fonction de la température possède la valeur ($\alpha_{R,N,presc}$) du coefficient de température ($\alpha_{R,N}$).

**5.** Dispositif selon la revendication 4, **caractérisé par le fait**

- **que** l'intensité (Iv) présentant le coefficient de température positif résulte d'une différence ($\Delta U_{be}$) des tensions base/émetteur ($U_{be}1$, $U_{be}2$) de deux autres transistors (V1, V2) qui sont exploités, en montage différentiel, avec des densités d'intensité différentes ($I_{C1}/A_1$, $I_{C2}/A_2$) et dont les deux émetteurs reliés ensemble sont alimentés par une première source d'intensité commune (8),
- **qu'**une seconde source d'intensité (9) alimente une première résistance (R2) dont les deux connexions sont reliées à une base respective des autres transistors (V1, V2), et
- **que** les deux sources d'intensité (8, 9) sont couplées ensemble de façon que leurs deux intensités (2 $I_f$, $I_V$) soient proportionnelles l'une à l'autre et que l'intensité de la seconde source d'intensité (9) soit l'intensité ($I_V$) présentant le coefficient de température positif.

**6.** Dispositif selon la revendication 5, **caractérisé par le fait que** le circuit base/émetteur, présentant la tension base/émetteur ($U_{be3,T}$) du premier transistor (V3), la résistance à semiconducteur en polysilicium ($R_1$, $R_2$, $R_3$, $R_4$) et la seconde source d'intensité (9) sont montées électriquement en série dans la séquence indiquée et que la résistance à semiconducteur en polysilicium ($R_1$, $R_2$, $R_3$, $R_4$) contient plusieurs résistances ($R_1$, $R_2$, $R_3$, $R_4$) montées électriquement en série, parmi lesquelles la première résistance (R2).

**7.** Dispositif selon la revendication 6, **caractérisé par le fait qu'**une deuxième et une troisième résistances (R3, R4) des résistances contenant une résistance à semiconducteur en polysilicium ($R_1$, $R_2$, $R_3$, $R_4$) sont disposées dans le circuit de série entre la seconde source d'intensité (9) et la première résistance (R2).

**8.** Dispositif selon la revendication 7, **caractérisé par le fait que** la troisième résistance (R4) est une résistance totale d'un potentiomètre ajustable (10) au point de prélèvement (10a) duquel apparaît en exploitation la tension de référence ($U_{R,N,T}$) fonction de la température et que la troisième résistance (R4) est disposée dans le circuit de série entre la deuxième résistance (R3) et la seconde source d'intensité (9).

**9.** Dispositif selon la revendication 8, **caractérisé par le fait que** le potentiomètre ajustable (10) est un potentiomètre numérique dont la résistance ajustable ($R_{Tr}$ = N.R5) peut se régler au moyen d'une valeur d'alignement (N).

**10.** Dispositif selon l'une des revendications 6 à 9, **caractérisé par le fait que** pour produire une tension de référence (UQ) fonction de la température, une quatrième résistance (R1) des résistances contenant une résistance à semiconducteur en polysilicium ($R_1$, $R_2$, $R_3$, $R_4$) est disposée dans le circuit de série entre le circuit base/émetteur du premier transistor (V3) et la première résistance (R2).

**11.** Dispositif selon l'une des revendications 1 à 10, **caractérisé par le fait qu'**une valeur d'une valeur d'alignement (N) est égale à une valeur, arrondie au nombre entier, de

$$N_K = [a_{R,0} - \alpha_{R,N,presc.} \cdot U_{R,0,35}]/[\alpha_{R,N,presc.} \cdot \Delta U_{R,\,35} - \Delta a_R]$$

avec

- $\alpha_{R,N,\,presc.}$ : valeur du coefficient de température ($\alpha_{R,N}$) de la tension de référence ($U_{R,N,T}$) fonction de la température,

- $U_{R,0,35}$ : valeur mesurée de la tension de référence ($U_{R,N,T}$) fonction de la température pour la température de référence ($T_0$) et une première valeur d'alignement ($N_1$),
- $U_{R,31,35}$ : valeur mesurée de la tension de référence ($U_{R,N,T}$) fonction de la température pour la température de référence ($T_0$) et une seconde valeur d'alignement ($N_2$),
- $U_{R,0,85}$ : valeur mesurée de la tension de référence ($U_{R,N,T}$) fonction de la température pour une seconde température de référence ($T_1$) et la première valeur d'alignement ($N_1$),
- $U_{R,31,85}$ : valeur mesurée de la tension de référence ($U_{R,N,T}$) fonction de la température pour la seconde température de référence ($T_1$) et la seconde valeur d'alignement ($N_2$).
- $a_{R,0} = [U_{R,0,85} - U_{R,0,35}]/\Delta T$,
- $a_{R,31} = [U_{R,31,85} - U_{R,31,35}]/\Delta T$,
- $\Delta a_R = [a_{R,31} - a_{R,0}]/\Delta N$,
- $\Delta U_{R,35} = [U_{R31,35} - U_{R,0,35}]/\Delta N$,
- $\Delta N$ : différence des deux valeurs d'alignement ($N_2$, $N_1$) et
- $\Delta T$ : différence ($T_1 - T_0$) des deux températures ($T_1$, $T_0$).

## Fig.1

$$K_{S,T} = K_{F,T} \cdot K_{A,T}$$

## Fig.2

# Fig. 3

EP 0 727 669 B1